# EUROPEAN PATENT APPLICATION

(11) **EP 4 550 957 A1**
(43) Date of publication of application: **07.05.2025**
(21) Application number: 24204677.9
(22) Date of filing: 04.10.2024
(51) Int. Cl.: H05K 7/20

(54) **MOTOR CONTROL UNIT FOR DOUBLE-SIDED HEAT DISSIPATION OF CAPACITOR MODULE, POWERTRAIN, AND VEHICLE**

(30) Priority: 30.10.2023 CN 202322941360 U
(71) Applicant: Huawei Digital Power Technologies Co., Ltd., Shenzhen, Guangdong 518043 (CN)
(72) Inventor: YU, Kang, Shenzhen, Guangdong (CN); XU, Ziyou, Shenzhen, Guangdong (CN); ZHANG, Weilong, Shenzhen, Guangdong (CN); GAO, Jiasheng, Shenzhen, Guangdong (CN); FAN, Chao, Shenzhen, Guangdong (CN)
(74) Representative: Maiwald GmbH

(57) **Abstract**

This application relates to the field of motor control unit technologies, and in particular, to a motor control unit for double-sided heat dissipation of a capacitor module (30), a powertrain, and a vehicle. The motor control unit includes a three-phase bridge arm (32), the capacitor module, a liquid cooling radiator (31), and a control unit housing (34). The control unit housing is configured to accommodate the three-phase bridge arm, the liquid cooling radiator, and the capacitor module. The three-phase bridge arm includes a plurality of power modules (320). The capacitor module includes a capacitor housing (300) and a capacitor core package (301), the capacitor housing is configured to accommodate the capacitor core package, and the capacitor housing includes two coolant through holes (3000c). The liquid cooling radiator includes a heat dissipation cavity, and the liquid cooling radiator is configured to dissipate heat for the plurality of power modules. The liquid cooling radiator and the capacitor housing are sequentially stacked on a bottom shell (34a) of the control unit housing in a first direction. The bottom shell of the control unit housing includes two coolant channels (340, 341), and each coolant channel communicates with the heat dissipation cavity of the liquid cooling radiator through one coolant through hole. In this application, the capacitor core package in the motor control unit for double-sided heat dissipation of a capacitor module implements double-sided heat dissipation, and has good heat dissipation effect and a long service life.

## Description

### TECHNICAL FIELD

This application relates to the field of motor control unit technologies, and in particular, to a motor control unit for double-sided heat dissipation of a capacitor module, a powertrain, and a vehicle.

### BACKGROUND

Currently, electric vehicles represented by pure electric vehicles and hybrid electric vehicles are increasingly popular among consumers, and internal space and comfort of the electric vehicle are also increasing. A motor control unit in the electric vehicle is configured to convert a direct current provided by a power battery into an alternating current to supply power to a drive motor, thereby driving wheels of the electric vehicle via the drive motor.

However, in the conventional technology, heat dissipation efficiency of a capacitor module in the motor control unit is low, which affects a service life of a capacitor core package in the capacitor module.

### SUMMARY

Embodiments of this application provide a motor control unit for double-sided heat dissipation of a capacitor module, a powertrain, and a vehicle. A layout of the motor control unit for double-sided heat dissipation of a capacitor module is compact, and a capacitor core package implements double-sided heat dissipation, and has good heat dissipation effect and a long service life.

According to a first aspect, this application provides a motor control unit for double-sided heat dissipation of a capacitor module. The motor control unit for double-sided heat dissipation of a capacitor module includes a three-phase bridge arm, a capacitor module, a liquid cooling radiator, and a control unit housing. The control unit housing is configured to accommodate the three-phase bridge arm, the liquid cooling radiator, and the capacitor module. The three-phase bridge arm includes a plurality of power modules. The capacitor module includes a capacitor housing and a capacitor core package, the capacitor housing is configured to accommodate the capacitor core package, and the capacitor housing includes two coolant through holes. The liquid cooling radiator includes a heat dissipation cavity, and the liquid cooling radiator is configured to dissipate heat for the plurality of power modules. The liquid cooling radiator and the capacitor housing are sequentially stacked on a bottom shell of the control unit housing in a first direction. The bottom shell of a control unit includes two coolant channels, and each coolant channel communicates with a radiator of the liquid cooling radiator through one coolant through hole. In this manner, the two coolant channels and the liquid cooling radiator are located on two sides of the capacitor core package in the first direction, and heat generated by the capacitor core package can be dissipated by the coolant channels and the heat dissipation cavity of the liquid cooling radiator, to improve heat dissipation effect on the capacitor core package. In addition, the coolant channel is located on the bottom shell, and compared with a heat dissipation structure outside the control unit housing, heat exchange effect between the capacitor core package and the external heat dissipation structure can also be improved.

In an embodiment, the two coolant channels include a liquid inlet flow channel and a liquid outlet flow channel, a liquid inlet of the liquid inlet flow channel is configured to communicate with the outside of the control unit housing, a liquid outlet of the liquid inlet flow channel is configured to communicate with one coolant through hole, a liquid inlet of the liquid outlet flow channel is configured to communicate with the other coolant through hole, a liquid outlet of the liquid outlet flow channel is configured to communicate with the outside of the control unit housing, and at least one of projection of the liquid inlet flow channel or projection of the liquid outlet flow channel partially overlaps projection of the capacitor core package in the first direction. A refrigerant enters the liquid inlet flow channel through the liquid inlet of the liquid inlet flow channel, and enters the heat dissipation cavity through the liquid outlet of the liquid inlet flow channel and one coolant through hole. After heat exchange in the heat dissipation cavity, the refrigerant enters the liquid inlet of the liquid outlet flow channel through the other coolant through hole, and flows out through the liquid outlet of the liquid outlet flow channel, to complete circulation. The at least one of the projection of the liquid inlet flow channel or the projection of the liquid outlet flow channel partially overlaps the projection of the capacitor core package in the first direction. This can ensure that the refrigerant can dissipate heat for the capacitor core package when passing through the liquid inlet flow channel and the liquid outlet flow channel.

In an embodiment, the control unit housing includes two side shells, the two side shells are fixedly connected to the bottom shell, and the capacitor module is arranged between the two side shells in a second direction. The liquid inlet of the liquid inlet flow channel is located on a side that is of one side shell and that is away from the capacitor module, and the liquid outlet of the liquid outlet flow channel is located on a side that is of the other side shell and that is away from the capacitor module. In a manner, the liquid outlet of the liquid outlet flow channel and the liquid inlet of the liquid inlet flow channel are located on two different side shells, so that mutual interference between an external pipeline and the liquid inlet of the liquid inlet flow channel and between an external pipeline and the liquid outlet of the liquid outlet flow channel can be reduced when the external pipeline is connected to the liquid inlet of the liquid inlet flow channel and the external pipeline is connected to the liquid outlet of the liquid outlet flow channel.

In an embodiment, in the first direction, a distance between the liquid inlet of the liquid inlet flow channel and the bottom shell of the control unit housing is greater than a distance between the liquid outlet of the liquid outlet flow channel and the bottom shell of the control unit housing, so that the refrigerant flows out through the liquid outlet of the liquid outlet flow channel. An opening direction of the liquid inlet of the liquid inlet flow channel is opposite to an opening direction of the liquid outlet of the liquid outlet flow channel in the second direction. This facilitates communication between the external pipeline and the liquid inlet of the liquid inlet flow channel and between the external pipeline and the liquid outlet of the liquid outlet flow channel. Projection of the liquid inlet of the liquid inlet flow channel and projection of the liquid outlet of the liquid outlet flow channel are spaced in a third direction, so that a layout of the pipeline connected to the liquid inlet of the liquid inlet flow channel and a layout of the pipeline connected to the liquid outlet of the liquid outlet flow channel can be more reasonable.

In an embodiment, in the first direction, the liquid outlet of the liquid inlet flow channel and the liquid inlet of the liquid outlet flow channel are arranged on a side that is of the bottom shell and that faces the capacitor module, and in a third direction, a distance between the liquid inlet of the liquid inlet flow channel and the liquid inlet of the liquid outlet flow channel and the liquid outlet of the liquid outlet flow channel is less than a length of the liquid cooling radiator and equal to a distance between the two coolant through holes. In this manner, it can be ensured that the refrigerant can enter the coolant through hole and the heat dissipation cavity of the liquid cooling radiator through the liquid outlet of the liquid inlet flow channel, and it can also be ensured that the refrigerant in the heat dissipation cavity can flow back to the liquid inlet of the liquid outlet flow channel through the coolant through hole.

In an embodiment, the capacitor module includes a copper bar, the copper bar passes through the capacitor housing, and the copper bar is configured to connect, in a thermally conductive manner, a side that is of the liquid cooling radiator and that faces the capacitor module to the capacitor core package, and a side that is of the liquid cooling radiator and that is away from the capacitor module is configured to fasten the plurality of power modules. The copper bar is disposed, so that heat dissipation efficiency between the capacitor core package and the liquid cooling radiator can be improved.

In an embodiment, the capacitor housing includes a first sub-housing and a second sub-housing, and a gap between the first sub-housing and the second sub-housing in the first direction is configured to accommodate the capacitor core package. In the first direction, a side that is of the first sub-housing and that is away from the second sub-housing is configured to fasten the liquid cooling radiator. The first sub-housing includes a hole and the two coolant through holes, and the copper bar is connected to the liquid cooling radiator through the hole. The two coolant through holes and the hole both penetrate the first sub-housing in the first direction, and the hole is arranged between the two coolant through holes in the third direction. In this manner, the hole is located between the two coolant through holes, so that it can be ensured that the copper bar is connected to a central position of the liquid cooling radiator, to improve heat dissipation efficiency between the liquid cooling radiator and the copper bar.

In an embodiment, the copper bar includes a first copper bar and a second copper bar, the first copper bar is located between the first sub-housing and the liquid cooling radiator in the first direction, and the second copper bar connects the first copper bar to the capacitor core package through the hole. A length of the first copper bar is greater than a length of the hole in the second direction. The first copper bar is fixedly connected to the second copper bar, the second copper bar transfers the heat generated by the capacitor core package to the first copper bar, and the first copper bar transfers the heat to the liquid cooling radiator.

In an embodiment, projection of the second copper bar in the third direction is U-shaped, to increase a contact area between the first copper bar and the second copper bar in the first direction, thereby improving a thermally conductive capability of the copper bar.

In an embodiment, the second copper bar includes a first section, a second section, and a third section that are sequentially connected, in the third direction, an end that is of the first section and that is away from the second section is configured to connect to the capacitor core package, in the third direction, an end that is of the third section and that is away from the second section is configured to connect to the capacitor core package, an included angle between the first section and the second section faces the capacitor core package in the first direction, and an included angle between the second section and the third section faces the capacitor core package in the first direction. In this manner, the contact area between the second copper bar and the first copper bar is larger, and stability of a connection between the second copper bar and the capacitor core package is stronger.

In an embodiment, a length of the hole is less than a width of the liquid cooling radiator in the second direction, to ensure that the liquid cooling radiator can completely cover the hole in the first direction.

In an embodiment, the capacitor housing includes two rows of fastening pillars, and the two rows of fastening pillars are configured to fasten the liquid cooling radiator. In the first direction, the two rows of fastening pillars are arranged on a side that is of the first sub-housing and that is away from the second sub-housing. A distance between the two rows of fastening pillars is greater than a length of the hole in the second direction, to ensure that the liquid cooling radiator can cover the hole after being mounted on the capacitor housing. Each row of fastening pillars includes a plurality of spaced fastening pillars in the third direction, so that stability of the liquid cooling radiator mounted on the capacitor housing can be improved.

According to a second aspect, an embodiment of this application provides a powertrain. The powertrain includes a motor and the motor control unit for double-sided heat dissipation of a capacitor module according to any technical solution of the first aspect, and the motor control unit is electrically connected to the motor. The motor control unit is configured to: convert a direct current provided by a power supply into an alternating current, and output the alternating current to the motor.

According to a third aspect, an embodiment of this application provides a vehicle. The vehicle includes wheels and the powertrain according to the technical solution of the second aspect. The powertrain is configured to: receive power supplied by a battery and drive the wheels, to drive the vehicle to travel.

### BRIEF DESCRIPTION OF DRAWINGS

FIG. 1 is a diagram of a vehicle according to an embodiment of this application;
FIG. 2 is a diagram of a vehicle and a powertrain according to an embodiment of this application;
FIG. 3 is an exploded view of a motor control unit for double-sided heat dissipation of a capacitor module according to an embodiment of this application;
FIG. 4 is a diagram of a partial structure of a capacitor module in a motor control unit for double-sided heat dissipation of the capacitor module according to an embodiment of this application;
FIG. 5 is a diagram of a structure in which a power module in a motor control unit for double-sided heat dissipation of a capacitor module is stacked on a liquid cooling radiator according to an embodiment of this application;
FIG. 6 is a diagram of a structure of a control unit housing in a motor control unit for double-sided heat dissipation of a capacitor module according to an embodiment of this application;
FIG. 7 is a diagram of another structure of a control unit housing in a motor control unit for double-sided heat dissipation of a capacitor module according to an embodiment of this application;
FIG. 8 is a diagram of still another structure of a control unit housing in a motor control unit for double-sided heat dissipation of a capacitor module according to an embodiment of this application;
FIG. 9 is a diagram of a structure of a capacitor housing in a motor control unit for double-sided heat dissipation of a capacitor module according to an embodiment of this application;
FIG. 10 is a top view in which a filter module in a motor control unit for double-sided heat dissipation of a capacitor module is mounted in the capacitor module according to an embodiment of this application;
FIG. 11 is a diagram of another partial structure of a capacitor module in a motor control unit for double-sided heat dissipation of the capacitor module according to an embodiment of this application; and
FIG. 12 is a bottom view of FIG. 10.

### Reference numerals:

1: vehicle; 10: vehicle body; 11: wheel; 12: vehicle-mounted load; 13: external power supply; 2: powertrain; 20: power supply module; 21: power battery; 22: motor; 3: motor control unit; 30: capacitor module; 300: capacitor housing; 3000: accommodating cavity; 3001a and 3001b: limiting member; 3002: first groove; 3000a: first sub-housing; 3000b: second sub-housing; 3000c: coolant through hole; 3000d: hole; 3000e: support pillar; 3000f: fastening pillar; 301: capacitor core package; 302: copper bar; 3020: first copper bar; 3021: second copper bar; 3021a: first section; 3021b: second section; 3021c: third section; 303: direct current output copper bar; 31: liquid cooling radiator; 310: coolant inlet; 311: coolant outlet; 32: three-phase bridge arm; 320: power module; 33: circuit board; 34: control unit housing; 34a: bottom shell; 34b: side shell; 340: liquid inlet flow channel; 341: liquid outlet flow channel; 342: liquid cooling pipe; 343: internal flow channel; 35: filter module; 350: filter; 351: grounding structure; 352: direct current connecting piece; 36: thermal insulation pad; 37: Hall magnetic core component; 370: Hall magnetic core; and 371: copper bar connecting piece.

### DESCRIPTION OF EMBODIMENTS

To make objectives, technical solutions, and advantages of this application clearer, the following further describes this application in detail with reference to accompanying drawings.

A motor control unit is a core component of a powertrain in the electric vehicle. Currently, electric vehicles represented by pure electric vehicles and hybrid electric vehicles are increasingly popular among consumers, and internal space and comfort of the electric vehicle are also increasing. The motor control unit in the electric vehicle is configured to convert a direct current provided by a power battery into an alternating current to supply power to a drive motor, thereby driving wheels of the electric vehicle via the drive motor.

However, the motor control unit includes components such as a capacitor module, a liquid cooling radiator, a power module, and a circuit board. In the conventional technology, there are a plurality of housings between a capacitor core package included in the capacitor module and the liquid cooling radiator, and heat generated by the capacitor core package needs to be transferred to the liquid cooling radiator via the plurality of housings. As a result, heat dissipation effect on the capacitor core package is poor, and a service life of the capacitor core package is affected.

In view of this, embodiments of this application provide a motor control unit, a powertrain, and a vehicle, to resolve the foregoing problems. To the make objectives, the technical solutions, and the advantages of this application clearer, the following further describes this application in detail with reference to the accompanying drawings.

Terms used in the following embodiments are merely intended to describe specific embodiments, but are not intended to limit this application. Terms "one", "a", "the", "the foregoing", "this" and "the one" of singular forms used in this specification and the appended claims of this application are also intended to include expressions such as "one or more", unless otherwise specified in the context clearly.

Referring to "an embodiment", "some embodiments", or the like in the specification of this application indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. Terms "include", "have", and their variants all mean "include but are not limited to", unless otherwise specifically emphasized in another manner.

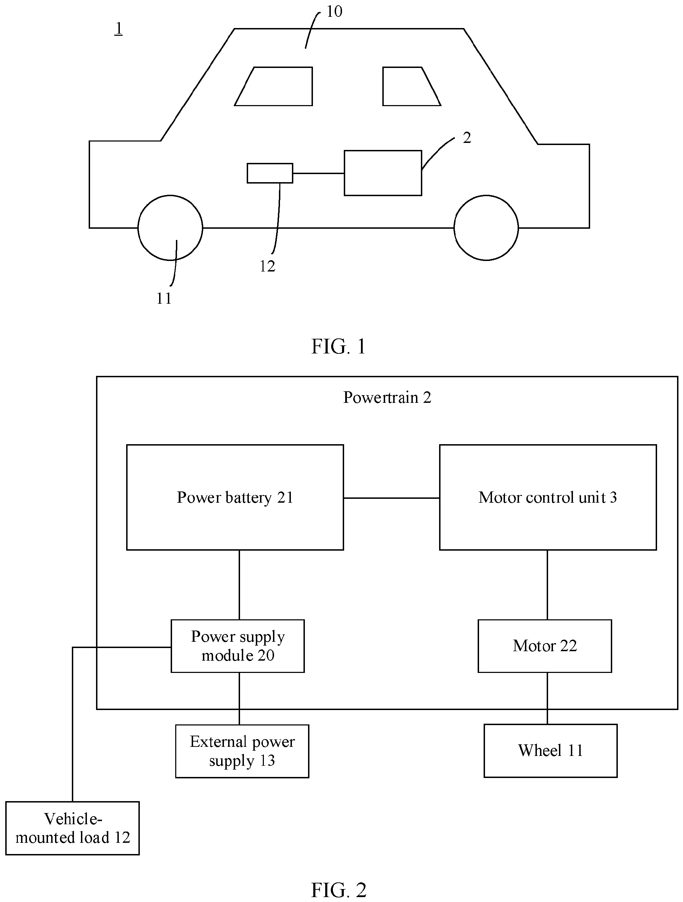

FIG. 1 is a diagram of a vehicle according to this application. Refer to FIG. 1. A vehicle 1 includes a vehicle body 10, wheels 11, a power battery 21, and a powertrain 2. The powertrain 2 is mounted on the vehicle body 10, and the power battery 21 supplies power to the powertrain 2. The powertrain 2 is configured to drive the wheels 11 of the vehicle 1. In an embodiment, the vehicle 1 includes the wheels 11 and the powertrain 2.

In this application, the vehicle 1 includes an electric vehicle (Electric Vehicle, EV), a battery electric vehicle (Battery Electric Vehicle, BEV), a hybrid electric vehicle (Hybrid Electric Vehicle, HEV), a range extended electric vehicle (Range Extended Electric Vehicle, REEV), a plug-in hybrid electric vehicle (Plug-in Hybrid Electric Vehicle, PHEV), or a new energy vehicle (New Energy Vehicle).

FIG. 2 is a diagram of a vehicle and a powertrain according to an embodiment of this application. As shown in FIG. 2, a vehicle 1 includes a vehicle body 10, wheels 11, a power battery 21, a power supply module 20, a vehicle-mounted load 12, and a powertrain 2.

In an embodiment, the powertrain 2 includes a motor control unit 3 and a motor 22. Refer to FIG. 2. The power battery 21 supplies power to the motor 22 via the motor control unit 3. The motor control unit 3 is configured to convert a direct current provided by the power battery 21 into an alternating current. The motor 22 receives the alternating current and converts the alternating current into kinetic energy to drive the wheels 11.

In an embodiment, the power supply module 20 is configured to: receive power supplied by an external power supply 13, and charge the power battery 21. In an embodiment, the power supply module 20 is configured to supply power to the vehicle-mounted load 12.

In this application, the external power supply 13 may be an alternating current power grid, an alternating current charging pile, or a direct current charging pile. The power supply module 20 may be a power distribution unit or an on-board charger. The vehicle-mounted load 12 includes at least one of a compressor, a battery heating module, a seat heating module, and a direct current low voltage power supply.

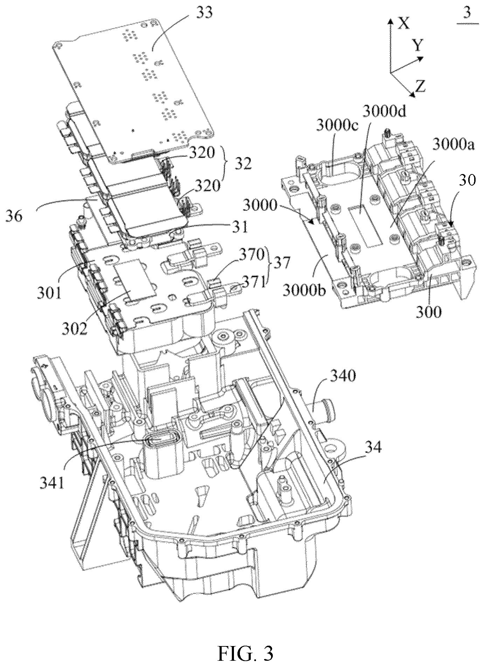

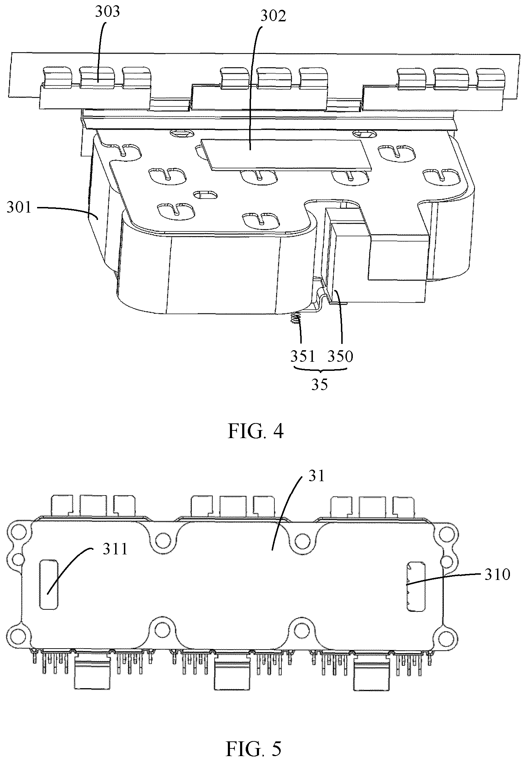

FIG. 3 is an exploded view of a motor control unit according to an embodiment of this application. FIG. 4 is a diagram of a partial structure of a capacitor module in a motor control unit according to an embodiment of this application. For ease of description, refer to FIG. 3 and FIG. 4.

In an embodiment, the motor control unit includes a control unit housing 34, a capacitor module 30, a liquid cooling radiator 31, a three-phase bridge arm 32, a circuit board 33, and a filter module 35.

The control unit housing 34 includes an accommodating cavity, and the accommodating cavity is used to accommodate the capacitor module 30, the liquid cooling radiator 31, the three-phase bridge arm 32, the circuit board 33, the filter module 35, and the like. The capacitor module 30, the liquid cooling radiator 31, the three-phase bridge arm 32, and the circuit board 33 are stacked in a first direction X. The three-phase bridge arm 32 includes a plurality of power modules 320, and the plurality of power modules 320 are spaced in a third direction Z. In an embodiment, the capacitor module 30, the three-phase bridge arm 32, the liquid cooling radiator 31, and the circuit board 33 are stacked in the first direction X, the three-phase bridge arm 32 is arranged on a side that is of the liquid cooling radiator 31 and that is away from the capacitor module 30, and in the first direction X, the filter module 35 is mounted on a side that is of the capacitor module 30 and that is away from the liquid cooling radiator 31.

In an embodiment, the capacitor module 30 includes a capacitor housing 300, a capacitor core package 301, and a plurality of groups of direct current output copper bars 303. The capacitor housing 300 is configured to accommodate the capacitor core package 301, and the plurality of groups of direct current output copper bars 303 are configured to electrically connect the capacitor core package 301 to the plurality of power modules 320. The plurality of groups of direct current output copper bars 303 are spaced in the third direction Z. The capacitor housing 300 includes two coolant through holes 3000c, and the two coolant through holes 3000c are configured to provide a refrigerant for the liquid cooling radiator 31.

FIG. 5 is a diagram of a structure in which the power module in the motor control unit is stacked on the liquid cooling radiator according to an embodiment of this application. Refer to FIG. 5. In an embodiment, the liquid cooling radiator 31 includes a heat dissipation cavity, a coolant inlet 310, and a coolant outlet 311. The coolant inlet 310 and the coolant outlet 311 communicate with the heat dissipation cavity. The coolant inlet 310 is configured to connect to one coolant through hole, and the coolant outlet 311 is configured to connect to the other coolant through hole.

Refer to FIG. 3, FIG. 4, and FIG. 5. In an embodiment, each power module 320 includes at least one power transistor. In an embodiment, power transistors of the plurality of power modules 320 are configured to form the three-phase bridge arm. Two bridge arm ends of each phase of bridge arm are configured to electrically connect to the capacitor core package 301, and a bridge arm midpoint of each phase of bridge arm circuit is configured to output an alternating current to drive a motor.

In an embodiment, the filter module 35 includes a filter 350, a direct current connecting piece, and a grounding structure 351. The filter 350 is configured to electrically connect to the capacitor core package 301 in the capacitor module 30. The direct current connecting piece is configured to receive a direct current output by a power battery 21. The filter 350 is configured to receive the direct current of the direct current connecting piece.

In this application, the direct current output by the power battery 21 is transmitted to the filter and the capacitor core package 301 via the direct current connecting piece, and the filter 350 and the capacitor core package 301 are configured to reduce a harmonic in the direct current. The circuit board 33 and the three-phase bridge arm formed by the plurality of power modules 320 receive the direct current, and output an alternating current to drive a motor 22. The circuit board 33 is configured to control running of the power transistor in the power module 320. The circuit board 33 controls a parameter of an alternating current output by an inverter circuit. The alternating current output by the three-phase bridge arm is transmitted to a three-phase winding of the motor 22 via a three-phase copper bar component.

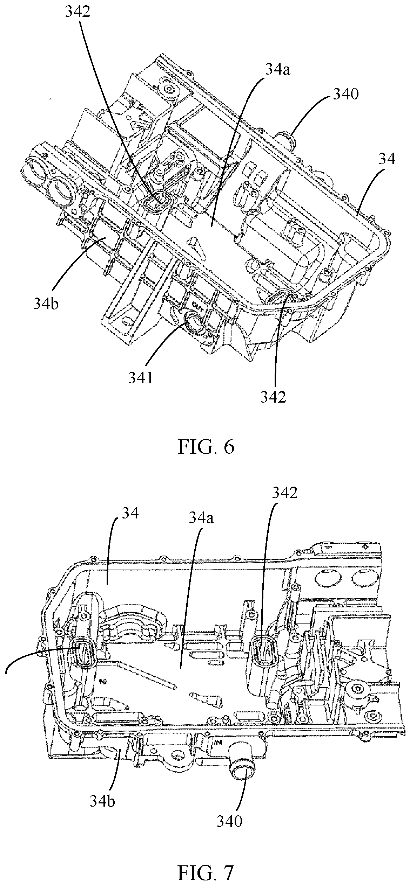

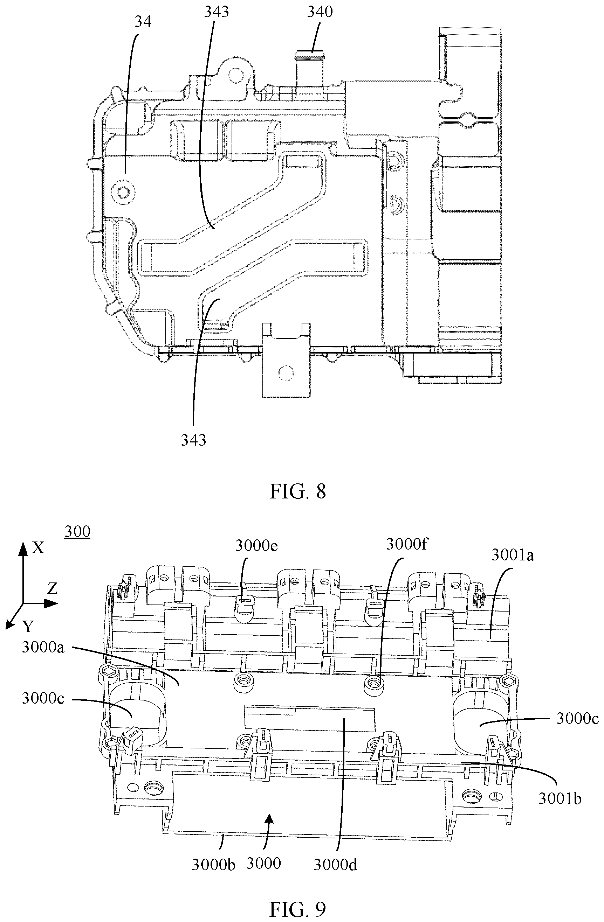

FIG. 6 is a diagram of a structure of the control unit housing in the motor control unit according to an embodiment of this application. FIG. 7 is a diagram of another structure of the control unit housing in the motor control unit according to an embodiment of this application. FIG. 8 is a diagram of still another structure of the control unit housing in the motor control unit according to an embodiment of this application. Refer to FIG. 3 and FIG. 5 to FIG. 8. In an embodiment, the control unit housing 34 includes two coolant channels, and each coolant channel communicates with the heat dissipation cavity of the liquid cooling radiator through one coolant through hole. The two coolant channels include a liquid inlet flow channel 340 and a liquid outlet flow channel 341, the liquid inlet flow channel 340 and the liquid outlet flow channel 341 are configured to connect to the heat dissipation cavity of the liquid cooling radiator 31, and the liquid inlet flow channel 340 and the liquid outlet flow channel 341 transmit the refrigerant to dissipate heat for the circuit board 33, the three-phase bridge arm 32, the capacitor module 30, the filter module 35, and the like in the motor control unit 3. A liquid outlet of the liquid inlet flow channel 340 is configured to communicate with one coolant through hole 3000c, and a liquid inlet of the liquid inlet flow channel 340 is configured to communicate with the outside of the control unit housing 34. The refrigerant flows into the liquid inlet flow channel 340 through the liquid inlet of the liquid inlet flow channel 340, and flows into the coolant through hole 3000c through the liquid outlet of the liquid inlet flow channel 340, to provide the refrigerant for the heat dissipation cavity of the liquid cooling radiator 31. A liquid inlet of the liquid outlet flow channel 341 is connected to the other coolant through hole 3000c, to communicate with the liquid cooling radiator 31, and a liquid outlet of the liquid outlet flow channel 341 is located outside the control unit housing 34, to discharge the refrigerant from the heat dissipation cavity of the liquid cooling radiator 31. Projection of the liquid inlet flow channel 340 and/or the liquid outlet flow channel 341 in the first direction X at least partially overlaps with the capacitor core package 301 included in the capacitor module 30. It may be understood as that, in the first direction X, the liquid inlet flow channel 340 and/or the liquid outlet flow channel 341 are/is at least partially arranged with the liquid cooling radiator 31 on two sides of the capacitor module, so that heat of the capacitor module 30 is dissipated on the two sides in the first direction X, thereby improving heat dissipation efficiency of the capacitor module 30.

The control unit housing 34 includes a bottom shell 34a and a plurality of side shells 34b, the plurality of side shells 34b are fixedly connected to the bottom shell 34a, and the plurality of side shells 34b are sequentially connected. The plurality of side shells 34b include two first side shells that are spaced in a second direction Y, and the capacitor module 30 is arranged between the two first side shells in the second direction Y In the second direction Y, the liquid inlet of the liquid inlet flow channel 340 is located on a side that is of one first side shell and that is away from the capacitor module, and in the second direction Y, the liquid outlet of the liquid outlet flow channel 341 is located on a side that is of the other first side shell and that is away from the capacitor module, to reduce a size of the control unit housing 34 in the first direction X. In an embodiment, an opening direction of the liquid inlet of the liquid inlet flow channel 340 is opposite to an opening direction of the liquid outlet of the liquid outlet flow channel 341 in the second direction Y An external pipeline in communication with an opening of the liquid inlet of the liquid inlet flow channel 340 and an external pipeline in communication with an opening of the liquid outlet of the liquid outlet flow channel 341 are located on two sides of the two first side shells, so that the external pipeline can be easily connected to the motor control unit. This improves convenience of mounting the motor control unit in a vehicle.

In the first direction, a distance between the liquid inlet of the liquid inlet flow channel 340 and the bottom shell is greater than a distance between the liquid outlet of the liquid outlet flow channel 341 and the bottom shell 34a. In a loop formed by the liquid inlet flow channel 340, the heat dissipation cavity, and the liquid outlet flow channel 341, the liquid inlet of the liquid inlet flow channel 340 is located above the liquid outlet of the liquid outlet flow channel 341 in the first direction X, so that the refrigerant can flow out of the liquid outlet of the liquid outlet flow channel 341 more conveniently.

In the first direction X, the liquid outlet of the liquid inlet flow channel 340 and the liquid inlet of the liquid outlet flow channel 341 are arranged on a side that is of the bottom shell 34a and that faces the capacitor module, to ensure that the liquid outlet of the liquid inlet flow channel 340 can communicate with one coolant through hole 3000c on the capacitor housing 300, and the liquid inlet of the liquid outlet flow channel 341 can communicate with the other coolant through hole 3000c on the capacitor housing 300. In addition, to improve convenience of connecting the liquid outlet of the liquid inlet flow channel 340 to one coolant through hole 3000c, and connecting the liquid inlet of the liquid outlet flow channel 341 to the other coolant through hole 3000c, in the third direction Z, a distance between the liquid outlet of the liquid inlet flow channel 340 and the liquid inlet of the liquid outlet flow channel 341 is equal to a distance between the two coolant through holes 3000c, so that the liquid outlet of the liquid inlet flow channel 340 and the liquid inlet of the liquid outlet flow channel 341 are aligned with the two coolant through holes 3000c in the first direction X, to ensure stability of refrigerant transmission. It should be noted that, in the third direction Z, the distance between the liquid outlet of the liquid inlet flow channel 340 and the liquid inlet of the liquid outlet flow channel 341 is less than a length of the liquid cooling radiator 31, to ensure that in the first direction X, the two coolant through holes 3000c are aligned with the coolant inlet 310 and the coolant outlet 311 included in the liquid cooling radiator 31.

Projection of the liquid inlet of the liquid inlet flow channel 340 and projection of the liquid outlet of the liquid outlet flow channel 341 are spaced in the third direction Z, and projection of the liquid inlet of the liquid outlet flow channel 341 and projection of the liquid outlet of the liquid inlet flow channel 340 are also spaced in the third direction Z. This arrangement manner can ensure that lengths of the liquid inlet flow channel 340 and the liquid outlet flow channel 341 are long, thereby improving heat dissipation capabilities of the liquid inlet flow channel 340 and the liquid outlet flow channel 341 for the capacitor core package, and improving the heat dissipation efficiency of the capacitor core package.

In an embodiment, the control unit housing 34 includes two liquid cooling pipes 342 and two internal flow channels 343, and the two internal flow channels 343 are located in the bottom shell 34a and the first side shells (which may be understood as two of the side shells 34b) of the control unit housing 34. The two liquid cooling pipes 342 are spaced on the bottom shell 34a of the control unit housing 34 in the third direction Z, and the two liquid cooling pipes 342 are configured to communicate with the two coolant through holes 3000c. One of the two liquid cooling pipes 342 is connected to one of the internal flow channels 343 to form the liquid inlet flow channel 340, and the other of the two liquid cooling pipes 342 is connected to the other of the internal flow channels 343 to form the liquid outlet flow channel 341. Projection of the capacitor core package 301 in the capacitor module 30 partially overlaps at least one internal flow channel 343 in the first direction X.

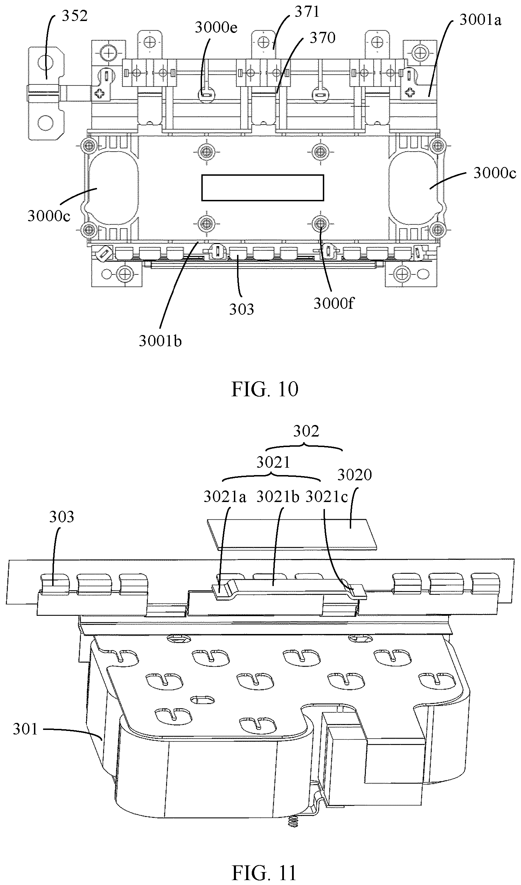

In an embodiment, the liquid inlet of the liquid inlet flow channel 340 is located on the bottom shell 34a, and the liquid outlet of the liquid outlet flow channel 341 is located on the bottom shell 34a. In an embodiment, the liquid inlet of the liquid inlet flow channel 340 is located on the first side shell, and the liquid outlet of the liquid outlet flow channel 341 is located on the bottom shell 34a. In an embodiment, the liquid inlet of the liquid inlet flow channel 340 is located on the bottom shell 34a, and the liquid outlet of the liquid outlet flow channel 341 is located on the first side shell. FIG. 9 is a diagram of a structure of the capacitor housing of the motor control unit according to an embodiment of this application. FIG. 10 is a main view in which the filter module in the motor control unit is mounted in the capacitor module according to an embodiment of this application. Refer to FIG. 3, FIG. 9, and FIG. 10. In an embodiment, the capacitor module 30 includes a copper bar 302, and the capacitor housing 300 includes a first sub-housing 3000a and a second sub-housing 3000b. An accommodating cavity 3000 is formed in a gap between the first sub-housing 3000a and the second sub-housing 3000b in the first direction X. The accommodating cavity 3000 is configured to accommodate the capacitor core package 301, and an opening direction of the accommodating cavity 3000 is in the second direction Y In a process in which the capacitor core package 301 is mounted in the accommodating cavity 3000 through an opening of the accommodating cavity 3000, the capacitor core package 301 does not interfere with the capacitor housing 300, so that convenience of assembling the motor control unit can be improved.

In an embodiment, the first sub-housing 3000a includes a hole 3000d and the two coolant through holes 3000c, both the two coolant through holes 3000c and the hole 3000d penetrate the first sub-housing 3000a in the first direction X, and the hole 3000d is in communication with the accommodating cavity 3000. The copper bar 302 penetrates the hole 3000d, and the copper bar 302 is connected to the capacitor core package 301 and the liquid cooling radiator 31. In this embodiment, a part of heat generated by the capacitor core package 301 can be transferred to the liquid cooling radiator 31 via the first sub-housing 3000a, and a part of heat generated by the capacitor core package 301 can be transferred to the liquid cooling radiator 31 via the copper bar 302, so that a heat dissipation speed of the capacitor core package 301 can be improved, and a service life of the capacitor core package 301 is increased.

In an embodiment, the opening 3000d is located between the two coolant through holes 3000c in the third direction Z, and distances from the opening 3000d to the coolant through holes 3000c are the same in the third direction Z, so that it can be ensured that the copper bar 302 located in the hole 3000d is located on a flow path of the refrigerant, it can be further ensured that the copper bar 302 is in contact with the liquid cooling radiator 31, and it can be further ensured that the copper bar 302 is connected to a center of the liquid cooling radiator 31, thereby improving thermal conductivity of the copper bar 302. In an embodiment, there are a plurality of holes 3000d, and one copper bar 302 is arranged in each hole 3000d.

In an embodiment, projection of the two coolant through holes 3000c does not overlap the projection of the capacitor core package 301 in the first direction X. Two coolant pipes or the two liquid cooling pipes 342 through which the refrigerant enters the two coolant through holes 3000c do not need to avoid the capacitor core package 301. This improves mounting convenience. There is a specific length between the two coolant through holes 3000c in the second direction Y, to ensure that when the refrigerant passes through the two coolant pipes or liquid cooling pipes 342, the two coolant pipes or liquid cooling pipes 342 are used as a cooling structure, to cool the capacitor core package 301.

In an embodiment, the distance between the two coolant through holes 3000c is less than the length of the liquid cooling radiator 31 in the third direction Z. The coolant inlet and the coolant outlet of the liquid cooling radiator 31 can correspond to the two coolant through holes 3000c respectively, to ensure that one of the two coolant through holes 3000c can transmit the refrigerant to the liquid cooling radiator 31, and also ensure that the refrigerant in the liquid cooling radiator 31 can flow out through the other of the two coolant through holes 3000c. The capacitor housing 300 integrates a function of transmitting the refrigerant. The refrigerant dissipates heat for the capacitor core package 301 in a process of being transmitted through the coolant pipe or the liquid cooling pipe 342, so that the capacitor housing 300 has a function of dissipating heat for the capacitor core package 301. This can improve integration of the motor control unit, and facilitates miniaturization of the motor control unit. A hole diameter of the coolant through hole 3000c is less than a width of the liquid cooling radiator in the second direction Y, so that the coolant inlet and the coolant outlet communicate with the coolant through hole. This can further ensure that the coolant does not leak.

In an embodiment, the coolant through hole 3000c is in a shape of a slotted hole, a circular hole, a rectangular hole, a rhombic hole, or the like.

In an embodiment, hole diameters of the two coolant through holes 3000c are greater than the coolant inlet 310 and the coolant outlet 311 of the liquid cooling radiator 31, so that sealing between the coolant through holes 3000c and the coolant inlet 310 and the coolant outlet 311 of the liquid cooling radiator 31 can be improved.

In an embodiment, sealing rings are disposed between the coolant through holes 3000c and the coolant inlet 310 and the coolant outlet 311 of the liquid cooling radiator 31, to ensure the sealing between the coolant through holes 3000c and the coolant inlet 310 and the coolant outlet 311 of the liquid cooling radiator 31.

FIG. 11 is a diagram of another partial structure of the capacitor module in the motor control unit according to an embodiment of this application. Refer to FIG. 3 and FIG. 11. In an embodiment, the copper bar 302 includes a first copper bar 3020 and a second copper bar 3021. The first copper bar 3020 is located between the first sub-housing and the liquid cooling radiator in the first direction X, and the first copper bar 3020 is configured to: enable the first sub-housing to face the liquid cooling radiator and connect the first sub-housing to the liquid cooling radiator. The second copper bar 3021 is connected to the first copper bar 3020 through the hole, so that heat absorbed by the second copper bar 3021 can be transferred to the first copper bar 3020. Projection of the first copper bar 3020 in the first direction X completely covers the second copper bar 3021, to ensure a contact area between the copper bar 302 and the liquid cooling radiator, and improve thermally conductive efficiency of the copper bar 302. It may be understood as that, the projection of the first copper bar 3020 in the first direction X covers at least a part of the hole, to ensure a contact area between the second copper bar 3021 and the first copper bar 3020.

In an embodiment, a length of the first copper bar 3020 is greater than a length of an opening on the first sub-housing in the third direction Z, to ensure that the first copper bar 3020 can be in contact with the liquid cooling radiator 31. This improves heat dissipation effect on the capacitor core package.

In an embodiment, projection of the second copper bar 3021 in the third direction Z is U-shaped. The U shape includes a first section 3021a, a second section 3021b, and a third section 3021c that are sequentially connected. In the third direction Z, an end that is of the first section 3021a and that is away from the second section 3021b and an end that is of the third section 3021c and that is away from the second section 3021b are connected to the capacitor core package 301. There is an included angle between the first section 3021a and the second section 3021b, and the included angle faces the capacitor core package 301 in the first direction. There is an included angle between the second section 3021b and the third section 3021c, and the included angle also faces the capacitor core package 301 in the first direction X. The first section 3021a and the third section 3021c are located on a same side of the second section 3021b in the third direction Z, the first section 3021a and the third section 3021c are configured to connect to the capacitor core package 301, the second section 3021b is located in the hole, and the second section 3021b is configured to connect to the first copper bar 3020. In the first direction X, a side that is of the second section 3021b and that faces the first copper bar 3020 is a plane, to increase the contact area between the first copper bar 3020 and the second copper bar 3021.

In the foregoing embodiment, still refer to FIG. 3. The motor control unit 3 includes a thermal insulation pad 36. The thermal insulation pad 36 is located between the liquid cooling radiator 31 and the copper bar 302 in the first direction X, and the thermal insulation pad 36 can improve thermally conductive efficiency between the copper bar 302 and the liquid cooling radiator 31. In an embodiment, the thermal insulation pad 36 is fastened to the liquid cooling radiator 31 in the first direction X. Projection of the thermal insulation pad 36 in the first direction X completely covers the copper bar 302, to ensure heat dissipation effect on the copper bar 302. In an embodiment, in the first direction X, the thermal insulation pad 36 is fastened to a side that is of the copper bar 302 and that faces the liquid cooling radiator 31. The projection of the thermal insulation pad 36 in the first direction X completely covers the copper bar 302, to ensure the heat dissipation effect on the copper bar 302.

In an embodiment, the capacitor module 30 includes a filling adhesive layer (not shown in the figure), and the filling adhesive layer is filled in the accommodating cavity. Filling adhesive included in the filling adhesive layer is thermally conductive adhesive. One end of the copper bar 302 is connected, in a thermally conductive manner, to the capacitor core package 301 through the filling adhesive layer. A part of heat generated by the capacitor core package 301 is transferred to the copper bar 302 through the filling adhesive layer, and the part of heat is transferred to the liquid cooling radiator 31 via the copper bar 302, to dissipate heat for the capacitor core package 301. In addition, heat is transferred between the capacitor core package 301 and the copper bar 302 through the filling adhesive layer, so that it can be ensured that no electrical connection is generated between the capacitor core package 301 and the copper bar 302. This improves working stability of the capacitor module 30.

In an embodiment, the motor control unit 3 includes two coolant pipes, each coolant pipe is connected to a coolant through hole 3000c, and projection of an extension path of each coolant pipe in the first direction X partially overlaps the capacitor core package 301. It may be understood as that, in the first direction X, a part of the coolant pipe and the liquid cooling radiator 31 are symmetrically arranged on two sides of the capacitor core package 301. In the first direction X, heat is dissipated via the liquid cooling radiator 31 on one side of the capacitor core package 301, and heat is dissipated through the coolant pipe on the other side of the capacitor core package 301. This improves the heat dissipation effect on the capacitor core package 301. In this manner, in the first direction X, the extension path of each coolant pipe passes through a side that is of the capacitor core package 301 and that is away from the liquid cooling radiator 31. The capacitor core package 301 is located between the two coolant pipes in the third direction, and the heat generated by the capacitor core package 301 can be absorbed by each coolant pipe twice, thereby improving the heat dissipation speed of the capacitor core package 301. In this manner, the two coolant pipes may be considered as two coolant channels.

In an embodiment, the coolant pipe is located in the control unit housing 34. The coolant pipe includes a coolant opening and a coolant connector, and two coolant openings are in communication with the two coolant through holes 3000c. The two coolant openings are spaced in the second direction Y, directions of the two coolant openings are in the first direction X, and a distance between the two coolant openings is the same as a distance between the coolant inlet and the coolant outlet of the liquid cooling radiator 31, to ensure that the two coolant pipes can be stably connected to the liquid cooling radiator 31. Two coolant connectors are located on the side shells of the control unit housing 34, and directions of the coolant connectors are in the second direction Y In an embodiment, the two coolant connectors are located on the bottom shell of the control unit housing 34, and the coolant connectors are in the first direction X. The refrigerant is provided for the coolant pipe via the bottom shell of the control unit housing 34. In an embodiment, the coolant pipe includes a first pipe and a second pipe, the first pipe and the second pipe are in communication with each other, and the first pipe is integrated on the bottom shell of the control unit housing 34. In this case, the first pipe may be considered as the liquid cooling pipe 342, and in the first direction, the second pipe extends towards a side that is of the second sub-housing and that is away from the first sub-housing, to dissipate heat for the capacitor core package.

In an embodiment, still refer to FIG. 3, FIG. 9, and FIG. 10. The motor control unit includes a plurality of Hall magnetic core components 37, and the plurality of Hall magnetic core components 37 are sequentially spaced on the first sub-housing 3000a of the capacitor housing in the third direction Z. The plurality of Hall magnetic core components 37 and the plurality of groups of direct current output copper bars 303 are arranged on two sides of the liquid cooling radiator 31 or the power module 320 respectively. It may be understood as that the plurality of Hall magnetic core components 37 and the plurality of groups of direct current output copper bars 303 are symmetrically arranged. In this embodiment, the plurality of Hall magnetic core components 37 and the plurality of groups of direct current output copper bars 303 are arranged on the two sides of the power module 320 or the liquid cooling radiator 31 respectively, so that space utilization of a side that is of the capacitor housing and that faces the liquid cooling radiator can be improved, thereby improving compactness of the motor control unit.

The Hall magnetic core component 37 includes a Hall magnetic core 370 and a copper bar connecting piece 371. The Hall magnetic core 370 includes a magnetic core through hole, and an axis of the magnetic core through hole is parallel to the second direction Y Each magnetic core through hole is configured to penetrate a copper bar connecting piece 371, and one end of the copper bar connecting piece 371 is configured to electrically connect to a power module 320, so that an alternating current of the power module 320 is output. When the copper bar connecting piece 371 penetrates the magnetic core through hole, there is no electrical connection between the copper bar connecting piece 371 and the Hall magnetic core 370. It may be understood as that, in the first direction X and the third direction Z, there is a gap between the copper bar connecting piece 371 and an inner wall of the magnetic core through hole, to ensure stability of the alternating current output via the copper bar connecting piece 371.

The Hall magnetic core 370 includes an opening. In the first direction X, the opening is located on a side that is of the Hall magnetic core 370 and that is away from the first sub-housing 3000a, and the opening is in communication with the magnetic core through hole. The opening is configured to accommodate a detection component. The detection component is configured to detect a current flowing through the copper bar connecting piece 371 or a voltage of the copper bar connecting piece 371.

Still refer to FIG. 9 and FIG. 10. The capacitor housing 300 includes a limiting member 3001a and a limiting member 3001b. The limiting member 3001a and the limiting member 3001b are spaced on the first sub-housing 3000a of the capacitor housing 300. The coolant through hole is located between the limiting member 3001a and the limiting member 3001b in the third direction Z.

The limiting member 3001a and the limiting member 3001b are arranged on two sides of the two coolant through holes 3000c in the second direction Y Space between the limiting member 3001a and the limiting member 3001b that are spaced is used to mount the liquid cooling radiator 31, and the limiting member 3001a and the limiting member 3001b can limit movement of the liquid cooling radiator 31 in a direction perpendicular to the first direction X and the third direction Z. It may be understood as that the limiting member 3001a and the limiting member 3001b can limit movement of the liquid cooling radiator 31 in the second direction Y, to improve stability of the liquid cooling radiator 31 mounted on the capacitor housing 300.

In an embodiment, the capacitor housing 300 includes two rows of fastening pillars 3000f. The two rows of fastening pillars 3000f are spaced between the limiting member 3001a and the limiting member 3001b, and the limiting member 3001a and the limiting member 3001b are configured to fasten the liquid cooling radiator 31.

In an embodiment, the two rows of fastening pillars 3000f, the limiting member 3001a, and the limiting member 3001b are located on a same side of the capacitor housing 300. Each row of fastening pillars 3000f includes a plurality of fastening pillars 3000f that are spaced in the third direction Z. The two rows of fastening pillars 3000f are spaced in the second direction Y, and the two rows of fastening pillars 3000f are configured to fasten the liquid cooling radiator 31.

In an embodiment, each row of fastening pillars 3000f includes four fastening pillars 3000f that are arranged in the third direction Z. A mounting region is formed between every four fastening pillars 3000f, and a plurality of mounting regions are used to mount the liquid cooling radiator 31. In the third direction Z, a mounting region located at one end corresponds to one coolant through hole 3000c, and a mounting region located at the other end corresponds to the other coolant through hole 3000c. The coolant inlet of the liquid cooling radiator 31 corresponds to one coolant through hole 3000c, and the coolant outlet of the liquid cooling radiator 31 corresponds to the other coolant through hole 3000c.

In this application, the capacitor housing 300 integrates the fastening pillar 3000f, and the liquid cooling radiator 31 is fastened to the capacitor housing 300 via the fastening pillar 3000f. This improves integration of the capacitor housing 300.

In an embodiment, the capacitor housing 300 includes two rows of support pillars 3000e. The two rows of support pillars 3000e, the two rows of fastening pillars 3000f, the limiting member 3001a, and the limiting member 3001b are located on a same side of the capacitor housing 300. The two rows of support pillars 3000e are arranged opposite to each other on two sides of the two rows of fastening pillars 3000f in the third direction Z.

In an embodiment, the two rows of support pillars 3000e are arranged opposite to each other on the two sides of the liquid cooling radiator 31 or the power module 320. The two rows of support pillars 3000e are configured to fasten the circuit board 33. In this application, the capacitor housing 300 integrates the two rows of support pillars 3000e, so that a structure layout of the motor control unit 3 is compact and highly integrated. This facilitates implementation of a miniaturization design of the motor control unit 3, and reduces difficulty in and costs of disassembling internal components of the motor control unit 3.

In an embodiment, each row of support pillars 3000e includes a plurality of support pillars 3000e that are spaced in the third direction Z. The limiting member 3001a and the limiting member 3001b integrate a row of support pillars 3000e in the second direction Y respectively. Correspondingly, a height of the support pillar 3000e is greater than a height of the fastening pillar 3000f in the first direction X. This can reduce a size of the capacitor housing 300 in the first direction X.

In an embodiment, each row of support pillars 3000e includes the plurality of support pillars 3000e that are spaced in the third direction Z. Each support pillar 3000e passes through the limiting member 3001a and the limiting member 3001b and is fastened to the first sub-housing 3000a of the capacitor housing 300 in the first direction X.

In an embodiment, each row of support pillars 3000e includes the plurality of support pillars 3000e that are spaced in the third direction Z. The two rows of support pillars 3000e are spaced in the second direction Y, the two rows of fastening pillars 3000f are spaced between the two rows of support pillars 3000e, and a distance between the two rows of fastening pillars 3000f is less than the width of the liquid cooling radiator 31. Correspondingly, the height of the support pillar 3000e is also greater than the height of the fastening pillar 3000f in the first direction X. This can reduce the size of the capacitor housing 300 in the first direction X.

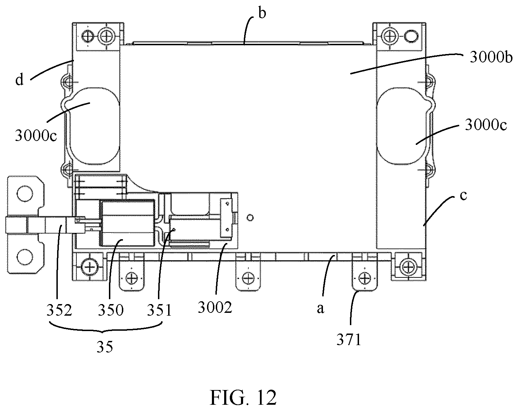

FIG. 12 is a bottom view of FIG. 10. Refer to FIG. 3 and FIG. 12. In an embodiment, in the first direction X, a side that is of the capacitor housing 300 and that is away from the liquid cooling radiator 31 includes a first groove 3002. In the first direction X, the first groove 3002 is located on a side that is of the second sub-housing 3000b and that is away from the first sub-housing 3000a, and the first groove 3002 is configured to accommodate the filter module 35. In this embodiment, the filter 350 included in the filter module 35 is mounted in the first groove 3002. One end of the direct current connecting piece 352 is electrically connected to the filter 350, and the other end of the direct current connecting piece 352 extends outside the capacitor housing 300. Projection of the direct current connecting piece 352 in the first direction X does not overlap the capacitor housing 300 and the plurality of groups of direct current output copper bars 303. The other end of the direct current connecting piece 352 and the plurality of Hall magnetic core components 37 are spaced in the second direction Y

The second sub-housing 3000b includes a first side a, a second side b, a third side c, and a fourth side d. The first side a is disposed opposite to the second side b, and the third side c is disposed opposite to the fourth side d. A part of the copper bar connecting piece 371 protrudes from the capacitor housing. The two coolant through holes 3000c are located between the first side a and the second side b. One of the two coolant through holes 3000c is close to the fourth side d, and the other of the two coolant through holes 3000c is close to the third side c. The distance between the two coolant through holes 3000c is large, so that mounting of the capacitor core package can be ensured, and when the refrigerant is provided for the two coolant through holes 3000c, another component does not need to be avoided. In some embodiments, the first groove 3002 is disposed between the coolant through hole 3000c close to the fourth side d and the copper bar connecting piece 371. It may be understood as that, after the filter 350 is mounted in the capacitor housing, the filter 350 is located between the coolant through hole 3000c close to the fourth side d and the copper bar connecting piece 371. One end of the direct current connecting piece 352 is connected to the filter 350, the other end of the direct current connecting piece 352 is located on the fourth side d, and the other end of the direct current connecting piece 352 extends towards a side of the first sub-housing, so that interference of the direct current connecting piece 352 to the copper bar connecting piece 371 is small. The direct current output copper bar 303 and the copper bar connecting piece 371 are arranged opposite to each other, and the direct current connecting piece 352 is far away from the direct current output copper bar 303. Therefore, the interference of the direct current connecting piece 352 to the direct current output copper bar 303 is smaller than that of the direct current connecting piece 352 to the copper bar connecting piece 371.

In some embodiments, a filter cavity is disposed between the coolant through hole 3000c close to the third side c and the copper bar connecting piece 371. It may be understood as that, after the filter 350 is mounted in the capacitor housing, the filter 350 is located between the coolant through hole 3000c close to the third side c and the copper bar connecting piece 371. One end of the direct current connecting piece 352 is connected to the filter 350, the other end of the direct current connecting piece 352 is located on the third side c, and the other end of the direct current connecting piece 352 extends towards the first sub-housing 3000a, so that the interference of the direct current connecting piece 352 to the copper bar connecting piece 371 is small. The direct current output copper bar 303 and the copper bar connecting piece 371 are arranged opposite to each other, and the direct current connecting piece 352 is far away from the direct current output copper bar 303. Therefore, the interference of the direct current connecting piece 352 to the direct current output copper bar 303 is smaller than that of the direct current connecting piece 352 to the copper bar connecting piece 371. The filter module 35 includes the grounding structure 351. The grounding structure 351 is connected to the filter 350, and is configured to improve working stability of the filter module 35.

It is clearly that a person skilled in the art can make various modifications and variations to this application without departing from the scope of this application. This application is intended to cover these modifications and variations of this application provided that they fall within the scope of protection defined by the following claims and their equivalent technologies.

## Claims

1. A motor control unit for double-sided heat dissipation of a capacitor module, wherein the motor control unit comprises:
a three-phase bridge arm, wherein the three-phase bridge arm comprises a plurality of power modules;
the capacitor module, wherein the capacitor module comprises a capacitor housing and a capacitor core package, the capacitor housing is configured to accommodate the capacitor core package, and the capacitor housing comprises two coolant through holes;
a liquid cooling radiator, wherein the liquid cooling radiator is configured to dissipate heat for the plurality of power modules, and the liquid cooling radiator comprises a heat dissipation cavity; and
a control unit housing, wherein the control unit housing is configured to accommodate the liquid cooling radiator and the capacitor housing, and the liquid cooling radiator and the capacitor housing are sequentially stacked on a bottom shell of the control unit housing in a first direction; and
the bottom shell of the control unit housing comprises two coolant channels, and each coolant channel communicates with the heat dissipation cavity of the liquid cooling radiator through one coolant through hole.

2. The motor control unit for double-sided heat dissipation of a capacitor module according to claim 1, wherein the two coolant channels comprise a liquid inlet flow channel and a liquid outlet flow channel, a liquid inlet of the liquid inlet flow channel is configured to communicate with the outside of the control unit housing, a liquid outlet of the liquid inlet flow channel is configured to communicate with one coolant through hole, a liquid inlet of the liquid outlet flow channel is configured to communicate with the other coolant through hole, a liquid outlet of the liquid outlet flow channel is configured to communicate with the outside of the control unit housing, and at least one of projection of the liquid inlet flow channel or projection of the liquid outlet flow channel partially overlaps projection of the capacitor core package in the first direction.

3. The motor control unit for double-sided heat dissipation of a capacitor module according to claim 2, wherein the control unit housing comprises two side shells, and the capacitor module is arranged between the two side shells in a second direction, wherein
the liquid inlet of the liquid inlet flow channel is located on a side that is of one side shell and that is away from the capacitor module, and
the liquid outlet of the liquid outlet flow channel is located on a side that is of the other side shell and that is away from the capacitor module.

4. The motor control unit for double-sided heat dissipation of a capacitor module according to claim 3, wherein an opening direction of the liquid inlet of the liquid inlet flow channel is opposite to an opening direction of the liquid outlet of the liquid outlet flow channel in the second direction.

5. The motor control unit for double-sided heat dissipation of a capacitor module according to claim 3 or 4, wherein in the first direction, a distance between the liquid inlet of the liquid inlet flow channel and the bottom shell of the control unit housing is greater than a distance between the liquid outlet of the liquid outlet flow channel and the bottom shell of the control unit housing.

6. The motor control unit for double-sided heat dissipation of a capacitor module according to claim 3 or 4, wherein projection of the liquid inlet of the liquid inlet flow channel and projection of the liquid outlet of the liquid outlet flow channel are spaced in a third direction.

7. The motor control unit for double-sided heat dissipation of a capacitor module according to claim 2, wherein in the first direction, the liquid outlet of the liquid inlet flow channel and the liquid inlet of the liquid outlet flow channel are arranged on a side that is of the bottom shell and that faces the capacitor module, and in a third direction, a distance between the liquid inlet of the liquid inlet flow channel and the liquid outlet of the liquid outlet flow channel is less than a length of the liquid cooling radiator and equal to a distance between the two coolant through holes.

8. The motor control unit for double-sided heat dissipation of a capacitor module according to any one of claims 1 to 7, wherein the capacitor module comprises a copper bar, the copper bar passes through the capacitor housing, and the copper bar is configured to connect, in a thermally conductive manner, a side that is of the liquid cooling radiator and that faces the capacitor module to the capacitor core package, and a side that is of the liquid cooling radiator and that is away from the capacitor module is configured to fasten the plurality of power modules.

9. The motor control unit for double-sided heat dissipation of a capacitor module according to claim 8, wherein the capacitor housing comprises a first sub-housing and a second sub-housing, a gap between the first sub-housing and the second sub-housing in the first direction is used to accommodate the capacitor core package, the first sub-housing comprises a hole and the two coolant through holes, and the hole is configured to penetrate the copper bar, wherein
the two coolant through holes and the hole penetrate the first sub-housing in the first direction, and
the hole is arranged between the two coolant through holes in the third direction.

10. The motor control unit for double-sided heat dissipation of a capacitor module according to claim 9, wherein the copper bar comprises a first copper bar and a second copper bar, the first copper bar is located between the first sub-housing and the liquid cooling radiator in the first direction, and the second copper bar connects the first copper bar to the capacitor core package through the hole;
projection of the second copper bar in the third direction is U-shaped.

11. The motor control unit for double-sided heat dissipation of a capacitor module according to claim 10, wherein the second copper bar comprises a first section, a second section, and a third section that are sequentially connected, in the third direction, an end that is of the first section and that is away from the second section is configured to connect to the capacitor core package, in the third direction, an end that is of the third section and that is away from the second section is configured to connect to the capacitor core package, an included angle between the first section and the second section faces the capacitor core package in the first direction, and an included angle between the second section and the third section faces the capacitor core package in the first direction.

12. The motor control unit for double-sided heat dissipation of a capacitor module according to any one of claims 9 to 11, wherein a length of the hole is less than a width of the liquid cooling radiator in the second direction.

13. The motor control unit for double-sided heat dissipation of a capacitor module according to any one of claims 9 to 11, wherein the capacitor housing comprises two rows of fastening pillars, and the two rows of fastening pillars are configured to fasten the liquid cooling radiator;
in the first direction, the two rows of fastening pillars are arranged on a side that is of the first sub-housing and that is away from the second sub-housing;
a distance between the two rows of fastening pillars is greater than a length of the hole in the second direction; and
each row of fastening pillars comprises a plurality of spaced fastening pillars in the third direction.

14. A powertrain, wherein the powertrain comprises a motor and the motor control unit for double-sided heat dissipation of a capacitor module according to any one of claims 1 to 13, and the motor control unit is configured to drive the motor.

15. A vehicle, wherein the vehicle comprises wheels and the powertrain according to claim 14, and the powertrain is configured to drive the wheels.
